# EUROPÄISCHE PATENTANMELDUNG

(11) **EP 2 863 277 A1**
(43) Veröffentlichungstag der Anmeldung: **22.04.2015**
(21) Anmeldenummer: 13188866.1
(22) Anmeldetag: 16.10.2013
(51) Int. Cl.: G05B 19/042

(54) **Verfahren zur Gerätesimulation**

(71) Anmelder: SICK AG, 79183 Waldkirch/Breisgau (DE)
(72) Erfinder: Convent, Jürgen, 79183 Waldkirch (DE); Beha, Martin, 79211 Denzlingen (DE); Wüst, Jochen, 79211 Denzlingen (DE)
(74) Vertreter: Manitz, Finsterwald & Partner GbR

(57) **Zusammenfassung**

Die Erfindung betrifft ein Verfahren zur Offline-Gerätesimulation eines Feldgeräts, bei der zumindest ein Parameter des Feldgeräts visualisiert und eine Parametrisierung des Feldgeräts ermöglicht wird und die Gerätesimulation auf der Grundlage einer Gerätebeschreibungsdatei generiert wird und wobei die Gerätesimulation in einem Browser ausgeführt wird.

## Beschreibung

Die vorliegende Erfindung betrifft ein Verfahren zur Offline-Gerätesimulation eines Feldgeräts, wobei zumindest ein Parameter des Feldgeräts visualisiert und eine Parametrisierung des Feldgeräts ermöglicht wird.

Insbesondere betrifft die Erfindung Feldgeräte der Prozessautomatisierung, also beispielsweise Transmitter, insbesondere O₂-Transmitter, Feldgeräte zur Rauchgasuntersuchung, wie z.B. Partikelmessgeräte, Laserscanner und dergleichen. Derartige Feldgeräte verfügen häufig über einen integrierten Webserver, über welchen das Feldgerät konfigurierbar bzw. parametrisierbar ist.

Zur Verbindung mit dem Webserver ist bei bekannten Lösungen zum Zwecke der Parametrisierung des Feldgeräts eine dauerhafte Datenverbindung zu dem Feldgerät notwendig, wobei eine dauerhafte Datenverbindung in bestimmten Betriebsumgebungen jedoch nicht realisierbar ist.

In diesem Zusammenhang beschreiben die DE 10 2007 062 395 A1 und die DE 10 2009 054 901 A1 die Parametrisierung eines Feldgeräts, wobei eine Gerätesoftware aus dem Feldgerät heruntergeladen und aus der Gerätesoftware des Feldgeräts eine Bedienoberfläche zur Parametrisierung des Feldgeräts erzeugt wird. Nach dem Erzeugen der Bedienoberfläche kann die Datenverbindung zu dem Feldgerät unterbrochen werden, wobei nach der Parametrisierung des Feldgeräts mittels der Bedienoberfläche die Datenverbindung wieder aufgebaut wird, um die eingestellten Parameter an das Feldgerät zu übertragen. Eine Datenverbindung ist somit bei der Initialisierung der Bedienoberfläche und der Übertragung der eingestellten Parameter notwendig. Auf eine Datenverbindung zu dem Feldgerät kann also auch hier nicht verzichtet werden. Weiterhin beschreibt die DE 10 2011 007 384 A1, dass eine Parametrisierung mittels einer Internetverbindung zu Server-Geräten ermöglicht wird. Die bekannten Verfahren arbeiten dementsprechend nicht offline.

Es ist daher eine der Erfindung zugrundeliegende Aufgabe, ein Verfahren zur Offline-Gerätesimulation eines Feldgeräts anzugeben, welches vollständig ohne eine Datenverbindung zu dem Feldgerät auskommt.

Erfindungsgemäß wird diese Aufgabe durch ein Verfahren gemäß Anspruch 1 und insbesondere dadurch gelöst, dass die Gerätesimulation in einem Browser ausgeführt wird und die Gerätesimulation auf der Grundlage einer Gerätebeschreibungsdatei generiert wird.

Dies bedeutet insbesondere, dass die Gerätesimulation bei einem erfindungsgemäßen Verfahren eine in einem Browser anzeigbare und/oder veränderbare Bedienoberfläche nutzt. Insbesondere basiert die Gerätesimulation somit ausschließlich auf Webtechnologien. Zur Ausführung der Gerätesimulation kann also die Installation von zusätzlicher Software entfallen, da die Gerätesimulation einen Browser zu ihrer Ausführung verwendet, welcher ohnehin auf nahezu jedem Rechner verfügbar ist. Die Gerätesimulation ermöglicht dabei insbesondere auch die Offline-Konfiguration, d.h. die Parametrisierung des simulierten Feldgeräts.

Die Gerätebeschreibungsdatei, die die Grundlage für die Gerätesimulation bildet, kann dabei z.B. bei der Entwicklung bzw. bei der Fertigung des Feldgeräts erstellt werden. Insbesondere kann die Gerätebeschreibungsdatei durch einen Entwickler manuell erstellt werden, wobei auf diese Weise festgelegt wird, welche Parameter des Feldgeräts einstellbar sind und wie diese visualisiert werden sollen. In der Gerätebeschreibungsdatei ist also zumindest ein parametrisierbarer Wert des Feldgeräts und dessen Visualisierung gespeichert. Darüber hinaus kann in der Gerätebeschreibungsdatei auch festgelegt sein, ob bei der Offline-Gerätesimulation des Feldgeräts mögliche Messwerte des Feldgeräts dargestellt werden, beispielsweise in Form von zufällig generierten Simulationswerten. Somit können mittels der Gerätesimulation z.B. Messbereiche, Messwerte, Messintervalle, Messdauern und/oder Abläufe von verschiedenen Funktionen eingestellt und simuliert werden. Beispielsweise können bei einem Partikelmessgerät zur Rauchgasuntersuchung das jeweilige Messintervall und die jeweilige Messdauer für eine bestimmte Partikelgröße einstellbar sein.

Die Gerätebeschreibungsdatei liegt dabei auf einem Rechner vor, auf welchem die Gerätesimulation erzeugt werden soll. Bei der Erzeugung der Gerätesimulation werden beispielsweise Beschreibungsdateien, wie z.B. HTML-Dateien, und/oder Scripte erzeugt, die von dem Browser ausgeführt werden könnnen. Bevorzugt wird die Gerätesimulation während der Entwicklung beim Hersteller einmalig erzeugt. Die Gerätesimulation kann alle für die Offline-Simulation im Browser notwendigen Daten enthalten. Durch die Generierung der Gerätesimulation auf der Grundlage der Gerätebeschreibungsdatei benötigt der Rechner keine Datenverbindung zu dem Feldgerät, sondern kann die Gerätesimulation allein auf der Grundlage der Gerätebeschreibungsdatei erzeugen. Dies ermöglicht die Offline-Gerätesimulation.

Da zur Generation der Gerätesimulation jeweils keine Datenverbindung zu dem zu simulierenden Feldgerät notwendig ist, können auf einem Rechner aus den entsprechenden Gerätebeschreibungsdateien auch mehrere verschiedene Gerätesimulationen verschiedener Feldgeräte erzeugt werden, die beispielsweise zu Schulungszwecken oder bei Kundenpräsentationen einsetzbar sind. Auch bei der Entwicklung von Feldgeräten kann die Gerätebeschreibungsdatei auf einfache Weise verändert werden, um verschiedene Konfigurationen eines zukünftigen Feldgeräts zu testen.

Vorteilhafte Ausführungsformen der Erfindung sind in der Beschreibung, der Zeichnung und den Unteransprüchen angegeben.

Gemäß einer vorteilhaften Ausführungsform ist die Gerätebeschreibungsdatei in einer Auszeichnungssprache, insbesondere in XML (eXtensible Markup Language), verfasst. Durch die Verwendung einer Auszeichnungssprache kann die Gerätebeschreibungsdatei plattformunabhängig sein, d.h. sie kann von verschiedenen Betriebssystemen, wie z.B. Windows, Linux, Mac OS und dergleichen, gelesen werden. Auch die aus der Gerätebeschreibungsdatei erzeugte Gerätesimulation kann plattformunabhängig sein.

Die Gerätebeschreibungsdatei kann zusätzlich auch für sogenannte Engineering-Tools verwendet werden, welche z.B. über serielle Schnittstellen eine Datenverbindung mit Feldgeräten herstellen, um diese zu parametrisieren.

Wird beispielsweise XML als Auszeichnungssprache verwendet, kann in der Gerätebeschreibungsdatei jeweils ein Element für jeden mit dem Feldgerät ermittelbaren Messwert vorgesehen sein, wobei in dem Element ein Attribut oder ein weiteres Element mit der für den jeweiligen Messwert vorgesehenen Visualisierung enthalten sein kann. Ebenfalls kann für jede Ausgabe (z.B. Messwertausgabe) und/oder jedes Bedienelement des Feldgeräts ein eigenes Element in der Gerätebeschreibungsdatei vorgesehen sein.

Beispielsweise kann eine Gerätebeschreibungsdatei im XML-Format wie folgt aufgebaut sein:

```
 <?xml version="1.0" encoding="UTF-8" standalone="yes"?>
 <device 1>
      <title>O2-Transmitter</title>
      <range>
           <start>0</start>
           <end>1000</end>
           <visualization>slider</visualization>
      </range>
      <measurement interval>
           <min>0</min>
           <max>400</max>
           <visualization>text</visualization>
      </measurement interval>
 </device 1>
```

Durch die vorstehende Gerätebeschreibungsdatei wird rein beispielhaft ein O₂-Transmitter beschrieben, welcher einen Messbereich ("range") von 0 bis 1000 Einheiten und mögliche Messintervalle ("measurement interval") von 0 bis 400 Einheiten beherrscht. Der Messbereich soll dabei als Schieberegler ("slider") und die Messintervalle als Textfeld ("text") in der Gerätesimulation visualisiert werden.

Bevorzugt wird die Gerätesimulation mittels eines Generatorprogramms aus der Gerätebeschreibungsdatei generiert. Das Generatorprogramm kann dazu die Gerätebeschreibungsdatei einlesen (d.h. "parsen") und aus den in der Gerätebeschreibungsdatei enthaltenen Informationen die Gerätesimulation erzeugen, wobei insbesondere die in der Gerätebeschreibungsdatei vorgegebene Visualisierung der einstellbaren Parameter des Feldgeräts durch das Generatorprogramm in eine Bedienoberfläche umgesetzt wird. Das Generatorprogramm kann zu diesem Zweck auf Bibliotheken zurückgreifen, in welchen konkrete Visualisierungen der einstellbaren Parameter hinterlegt sind. Beispielsweise können die Parameter mittels Schiebereglern, Drehreglern, per Texteingabe und dergleichen eingestellt werden.

Eine einmal von dem Generatorprogramm erzeugte Gerätesimulation, die z.B. vom Hersteller des Feldgeräts generiert wurde, kann dabei gespeichert bleiben, um diese immer wieder verwenden zu können. Bevorzugt können verschiedene Gerätesimulationen verschiedener Feldgeräte und/oder verschiedene Gerätebeschreibungsdateien durch einen Hersteller zentral für Kunden zur Verfügung gestellt werden. Alternativ kann die Gerätesimulation beim Aufrufen der Gerätebeschreibungsdatei jeweils neu erstellt werden, wodurch eventuelle zwischenzeitliche Änderungen der Gerätebeschreibungsdatei berücksichtigt werden können. Das Generatorprogramm kann dafür derart modular und flexibel ausgestaltet sein, sodass unterschiedliche Gerätebeschreibungsdateien verschiedener Feldgeräte in jeweils verschiedene Gerätesimulationen umsetzbar sind.

Bevorzugt ist das Generatorprogramm auf das benötigte Zielformat und/oder die zur Ausführung der Gerätesimulation verwendete Rechnerplattform abgestimmt. Es kann somit für jede Rechnerplattform ein eigenes Generatorprogramm vorgesehen sein, welches spezifische Anforderungen der jeweiligen Rechnerplattform berücksichtigt.

Gemäß einer vorteilhaften Ausführungsform der Erfindung umfasst die Gerätesimulation eine HTML-Datei (Hypertext Markup Language-Datei) und/oder eine CSS-Datei (Cascading Style Sheets-Datei) und/oder eine JavaScript-Datei und/oder eine Flash-Datei und/oder eine Bilddatei. Weiterhin kann die Gerätesimulation auch Video-Dateien, Java-Dateien und dergleichen umfassen. Insbesondere kann die HTML-Datei auf die übrigen genannten Dateien verweisen und beispielsweise eine Flash-Datei aufrufen, wenn die HTML-Datei von dem Browser geladen wird. Anstelle einer HTML-Datei kann durch das Generatorprogramm auch jedes andere von einem Browser interpretierbare Dateiformat erzeugt werden.

Alternativ kann das Generatorprogramm auch ein Browser Plug-In erzeugen, das von einem Browser ausgeführt wird und dessen Funktion erweitert. Durch das Browser Plug-In kann die Funktionsfähigkeit des Browsers derart erweitert werden, dass durch den Browser die Gerätesimulation visualisiert werden kann.

Die Gerätesimulation kann auf der Rechnerplattform des Browsers ausgeführt werden, wodurch es sich um eine clientseitig ausgeführte Webapplikation handelt. Gemäß einer weiteren vorteilhaften Ausführungsform sind die Dateien der Gerätesimulation in einer Archivdatei verpackt, die zur Ausführung der Gerätesimulation entpackt wird. Die Archivdatei kann z.B. im ZIP-Format, im RAR-Format (Roshal Archive) oder als selbstextrahierendes Archiv, beispielsweise als ausführbare EXE-Datei, vorliegen. Das Generatorprogramm kann also anstelle einzelner Dateien auch eine Archivdatei erzeugen, die dann entpackt wird, wenn die Gerätesimulation ausgeführt werden soll.

Gemäß einer weiteren vorteilhaften Ausführungsform sind die Dateien der Gerätesimulation lokal gespeichert. Dies bedeutet, die Dateien der Gerätesimulation sind auf der den Browser ausführenden Rechnerplattform gespeichert.

Gemäß einer weiteren vorteilhaften Ausführungsform sind die Dateien der Gerätesimulation auf einem Server gespeichert und werden von dem Server abgerufen. Der den Browser ausführende Rechner kann alternativ oder zusätzlich die Dateien der Gerätesimulation von dem Server abrufen, wenn der Rechner eine Datenverbindung zu dem Server besitzt.

Zusätzlich kann die Gerätesimulation als Anwendungssoftware für Mobilgeräte und/oder als Browser Plug-In vorliegen. Das Generatorprogramm kann die Gerätesimulation alternativ oder zusätzlich als Anwendungssoftware für Mobilgeräte (App) und/oder als Browser Plug-In erzeugen, wobei sämtliche von dem Generatorprogramm erzeugten Gerätesimulationen im Wesentlichen den gleichen Funktionsumfang besitzen, wenn sie auf der Grundlage der gleichen Gerätebeschreibungsdatei generiert wurden. Die Gerätesimulation kann beispielsweise für das Android-Betriebssystem, für das iOS-Betriebssystem, für den Firefox-Browser, für den Chrome-Browser usw. vorliegen.

Bevorzugt wird eine vorgenommene Parametrisierung des Feldgeräts gespeichert, insbesondere auf einem Server und/oder lokal. Die vorgenommene Parametrisierung, d.h. die Konfigurationseinstellungen, können auf den Server übertragen und dort gespeichert werden.

Gemäß einer weiteren vorteilhaften Ausführungsform wird die vorgenommene Parametrisierung lokal, z.B. durch browsereigene Mechanismen, wie Cookies, "Local Storage" oder mittels Browser Plug-In in lokal zugreifbarem Speicher abgelegt. Eine abgespeicherte Parametrisierung kann bei einer späteren Weiterverwendung der Gerätesimulation wieder geladen werden, um die Parametrisierung fortzusetzen oder abzuändern.

Wird die Gerätesimulation beispielsweise zu Schulungszwecken oder bei Verkaufsveranstaltungen eingesetzt wird eine vorgenommene Parametrisierung üblicherweise nur abgespeichert oder nach der Verwendung wieder gelöscht bzw. verworfen.

Alternativ wird die vorgenommene Parametrisierung an das Feldgerät übertragen. Dies kann zum Beispiel erfolgen, um eine vorgenommen Parametrisierung an einem realen Feldgerät zu testen. Beispielsweise kann die Parametrisierung auf einem USB-Speicherstick gespeichert werden und durch Einstecken des USB-Speichersticks an dem Feldgerät auf das Feldgerät übertragen werden. Auf diese Weise kann die Parametrisierung des Feldgeräts vorgenommen werden, ohne dass eine direkte Datenverbindung zu dem Feldgerät bestehen muss. Wird die auf einem USB-Speicherstick gespeicherte Parametrisierung an mehrere Feldgeräte nacheinander übertragen, so kann sichergestellt werden, dass alle diese Feldgeräte auf der Grundlage der gleichen Einstellungen arbeiten. Dies ist insbesondere beim Einbau neuer Feldgeräte z.B. in eine bestehende Anlage vorteilhaft, da somit die Parametrisierung der Feldgeräte bereits vor deren Einbau, d.h. offline, erfolgen kann.

Wahlweise kann die vorgenommene Parametrisierung auch über eine direkte Datenverbindung, beispielsweise über Ethernet, Internet und/oder Feldbus an das Feldgerät übertragen werden. Ebenfalls kann die Parametrisierung über eine serielle Schnittstelle des Feldgeräts an dieses übertragen werden, beispielsweise unter Verwendung eines Engineering-Tools.

Rein beispielhaft kann eine Gerätesimulation also dadurch erzeugt werden, dass zunächst eine Gerätebeschreibungsdatei erstellt wird, in der gespeichert ist, welche Parameter des Feldgeräts einstellbar und visualisierbar sind. Die Gerätebeschreibungsdatei wird anschließend mittels eines Generatorprogramms z.B. in ein Archiv umgesetzt, wobei in dem Archiv eine HTML-Datei und eine JavaScript-Anwendung enthalten sind. Die HTML-Datei kann auf die JavaScript-Anwendung verweisen, wobei durch Aufruf der HTML-Datei in einem Browser die JavaScript-Anwendung ausgeführt wird und zusammen mit der HTML-Datei die Gerätesimulation darstellt. Ein Benutzer kann in einem Browser die Gerätesimulation aufrufen und dazu verwenden, das Feldgerät nach seinen Wünschen zu parametrisieren. Geänderte Parameter können lokal oder auf einem Server gespeichert werden und zur tatsächlichen Veränderung der Parametrisierung eines realen Feldgeräts beispielsweise direkt mittels eines Browsers oder mittels eines USB-Speichersticks an das Feldgerät übertragen werden.

Nachfolgend wird die Erfindung rein beispielhaft unter Bezugnahme auf die beigefügte Zeichnung beschrieben. Es zeigt:

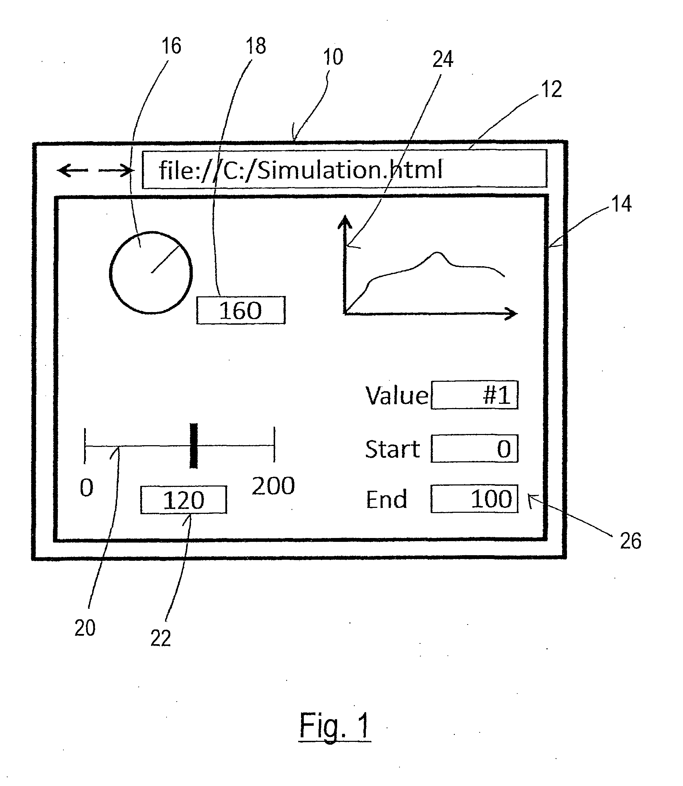

- Fig. 1: eine schematische Darstellung einer von einem Browser angezeigten Bedienoberfläche einer Offline-Gerätesimulation.

In Fig. 1 ist schematisch ein Browserfenster 10 dargestellt, wobei in einer Adresszeile 12 des Browserfensters 10 eine lokale HTML-Datei (Simulation.html) aufgerufen ist, in der eine Gerätesimulation 14 gespeichert ist. Die Gerätesimulation 14 stellt eine virtuelle Repräsentation eines Feldgeräts (nicht gezeigt) dar, zeigt Parameter des Feldgeräts an und ermöglicht eine Veränderung der dargestellten Parameter.

Die Gerätesimulation 14 umfasst einen visualisierten Drehknopf 16, mittels welchem beispielsweise ein Messintervall in Millisekunden einstellbar ist. Das eingestellte Messintervall wird in einem ersten Textfeld 18 angezeigt.

Ein Messbereich des Feldgeräts ist mittels eines Schiebereglers 20 einstellbar, wobei eine aktuell gewählte Messbereichsobergrenze in einem zweiten Textfeld 22 dargestellt ist.

Die Gerätesimulation 14 umfasst weiterhin die Darstellung eines Graphen 24, in welchem simulierte Messwerte des Feldgeräts dargestellt sind. Die simulierten Messwerte können durch die Gerätesimulation 14 zum Zwecke der Veranschaulichung z.B. zufällig erzeugt werden.

Die in dem Graph 24 dargestellten Werte können durch einen drei Textfelder umfassenden Einstellbereich 26 ausgewählt werden.

### Bezugszeichenliste

- 10: Browserfenster
- 12: Adresszeile
- 14: Gerätesimulation
- 16: Drehknopf
- 18: erstes Textfeld
- 20: Schieberegler
- 22: zweites Textfeld
- 24: Graph
- 26: Einstellbereich

## Patentansprüche

1. Verfahren zur Offline-Gerätesimulation eines Feldgeräts, bei der zumindest ein Parameter des Feldgeräts auf einer Anzeigeeinheit visualisiert und eine Parametrisierung des Feldgeräts ermöglicht wird und die Gerätesimulation (14) auf der Grundlage einer Gerätebeschreibungsdatei generiert wird und wobei die Gerätesimulation (14) in einem Browser (10) ausgeführt wird.

2. Verfahren nach Anspruch 1,
**dadurch gekennzeichnet, dass**
die Gerätebeschreibungsdatei in einer Auszeichnungssprache, insbesondere in XML, verfasst ist.

3. Verfahren nach Anspruch 1 oder 2,
**dadurch gekennzeichnet, dass**
die Gerätesimulation (14) mittels eines Generatorprogramms aus der Gerätebeschreibungsdatei generiert wird.

4. Verfahren nach Anspruch 3,
**dadurch gekennzeichnet, dass**
das Generatorprogramm auf das benötigte Zielformat und/oder die zur Ausführung der Gerätesimulation (14) verwendete Rechnerplattform abgestimmt ist.

5. Verfahren nach einem der vorstehenden Ansprüche,
**dadurch gekennzeichnet, dass** die Gerätesimulation (14) eine HTML-Datei und/oder eine CSS-Datei und/oder eine Javascript-Datei und/oder eine Flash-Datei und/oder eine Bilddatei umfasst.

6. Verfahren nach Anspruch 5,
**dadurch gekennzeichnet, dass** die Dateien der Gerätesimulation (14) in einer Archivdatei verpackt sind, die zur Ausführung der Gerätesimulation (14) entpackt wird.

7. Verfahren nach einem der vorstehenden Ansprüche,
**dadurch gekennzeichnet, dass** die Dateien der Gerätesimulation (14) lokal gespeichert sind.

8. Verfahren nach einem der vorstehenden Ansprüche,
**dadurch gekennzeichnet, dass** die Dateien der Gerätesimulation (14) auf einem Server gespeichert sind und von dem Server abgerufen werden.

9. Verfahren nach einem der vorstehenden Ansprüche,
**dadurch gekennzeichnet, dass** die Gerätesimulation (14) als Anwendungssoftware für Mobilgeräte und/oder als Browser Plug-In vorliegt.

10. Verfahren nach einem der vorstehenden Ansprüche,
**dadurch gekennzeichnet, dass** eine vorgenommene Parametrisierung des Feldgeräts gespeichert wird, insbesondere auf einem Server und/oder lokal.

11. Verfahren nach Anspruch 10,
**dadurch gekennzeichnet, dass** die vorgenommene Parametrisierung durch browsereigene Mechanismen, wie Cookies, "Local Storage" oder mittels Browser Plug-In in einem lokal zugreifbarem Speicher abgelegt wird.

## Geänderte Patentansprüche

### Geänderte Patentansprüche gemäss Regel 137(2) EPÜ.

1. Verfahren zur Offline-Gerätesimulation eines Feldgeräts, welches vollständig ohne eine Datenverbindung zu dem Feldgerät auskommt, bei welchem zumindest ein Parameter des Feldgeräts auf einer Anzeigeeinheit visualisiert und eine Parametrisierung des Feldgeräts ermöglicht wird und die Gerätesimulation (14) auf der Grundlage einer Gerätebeschreibungsdatei generiert wird, wobei die Gerätesimulation (14) in einem Browser (10) ausgeführt wird und die Gerätesimulation (14) alle für die Offline-Gerätesimulation im Browser (10) notwendigen Daten enthält.

2. Verfahren nach Anspruch 1,
**dadurch gekennzeichnet, dass**
die Gerätebeschreibungsdatei in einer Auszeichnungssprache, insbesondere in XML, verfasst ist.

3. Verfahren nach Anspruch 1 oder 2,
**dadurch gekennzeichnet, dass**
die Gerätesimulation (14) mittels eines Generatorprogramms aus der Gerätebeschreibungsdatei generiert wird.

4. Verfahren nach Anspruch 3,
**dadurch gekennzeichnet, dass**
das Generatorprogramm auf das benötigte Zielformat und/oder die zur Ausführung der Gerätesimulation (14) verwendete Rechnerplattform abgestimmt ist.

5. Verfahren nach einem der vorstehenden Ansprüche,
**dadurch gekennzeichnet, dass**
die Gerätesimulation (14) eine HTML-Datei und/oder eine CSS-Datei und/oder eine Javascript-Datei und/oder eine Flash-Datei und/oder eine Bilddatei umfasst.

6. Verfahren nach Anspruch 5,
**dadurch gekennzeichnet, dass**
die Dateien der Gerätesimulation (14) in einer Archivdatei verpackt sind, die zur Ausführung der Gerätesimulation (14) entpackt wird.

7. Verfahren nach einem der vorstehenden Ansprüche,
**dadurch gekennzeichnet, dass**
die Dateien der Gerätesimulation (14) lokal auf einer den Browser (10) ausführenden Rechnerplattform gespeichert sind.

8. Verfahren nach einem der vorstehenden Ansprüche,
**dadurch gekennzeichnet, dass**
die Dateien der Gerätesimulation (14) auf einem Server gespeichert sind und von dem Server abgerufen werden.

9. Verfahren nach einem der vorstehenden Ansprüche,
**dadurch gekennzeichnet, dass**
die Gerätesimulation (14) als Anwendungssoftware für Mobilgeräte und/oder als Browser Plug-In vorliegt.

10. Verfahren nach einem der vorstehenden Ansprüche,
**dadurch gekennzeichnet, dass**
eine vorgenommene Parametrisierung des Feldgeräts gespeichert wird, insbesondere auf einem Server und/oder lokal.

11. Verfahren nach Anspruch 10,
**dadurch gekennzeichnet, dass**
die vorgenommene Parametrisierung durch browsereigene Mechanismen, wie Cookies, "Local Storage" oder mittels Browser Plug-In in einem lokal zugreifbarem Speicher abgelegt wird.
